# FASCICULE DE BREVET EUROPEEN

(11) **EP 3 002 511 B1**
(45) Date de publication et mention de la délivrance du brevet: **30.01.2019**
(21) Numéro de dépôt: 15186929.4
(22) Date de dépôt: 25.09.2015
(51) Int. Cl.: F21S 41/00

(54) **DISPOSITIF À COMPOSANT SEMI-CONDUCTEUR MONTÉ SUR UN DISSIPATEUR DE CHALEUR, PROCÉDÉ DE MONTAGE, ET DISPOSITIF D'ÉCLAIRAGE POUR VÉHICULE AUTOMOBILE COMPORTANT UN TEL DISPOSITIF**
VORRICHTUNG MIT HALBLEITERKOMPONENTE, DIE AUF EINEM WÄRMEABLEITER MONTIERT IST, MONTAGEVERFAHREN UND EINE SOLCHE VORRICHTUNG UMFASSENDE BELEUCHTUNGSVORRICHTUNG FÜR KRAFTFAHRZEUG
DEVICE WITH SEMICONDUCTOR COMPONENT MOUNTED ON A HEAT SINK, MOUNTING METHOD, AND LIGHTING DEVICE FOR A MOTOR VEHICLE COMPRISING SUCH A DEVICE

(30) Priorité: 30.09.2014 FR 1459309
(43) Date de publication de la demande: 06.04.2016
(73) Titulaire: VALEO VISION, 93012 Bobigny (FR)
(72) Inventeur: MORNET, Eric, 94130 NOGENT SUR MARNE (FR); LETOUMELIN, Rémi, 77700 CHESSY (FR); PUENTE, Jean-Claude, 93190 LIVRY GARGAN (FR); DUCLOUX, Bruno, 89100 SENS (FR); YACOUBI, Nadia, 93000 BOBIGNY (FR); MATTE, Fanck, 95490 VAUREAL (FR); JACQUEMIN, Didier, 10320 Longeville sur Mogne (FR)

(56) Documents cités:
- EP-A1- 2 177 398
- DE-U1-202004 003 793
- FR-A1- 2 889 290
- JP-A- 2014 164 876

## Description

L'invention concerne un dispositif à composant semi-conducteur monté sur un dissipateur de chaleur, le composant semi-conducteur étant connecté à un élément d'interconnexion électrique.

L'invention porte en outre sur un procédé de montage du dispositif susmentionné, et sur un dispositif lumineux pour véhicule automobile comportant un tel dispositif.

La présente invention trouve son application plus particulièrement dans le cadre du montage d'une source de lumière dans un projecteur de véhicule automobile.

Dans le domaine de l'éclairage automobile, il est connu, lorsque l'on utilise des diodes électroluminescentes (ou LEDs pour « *Light-Emitting Diodes* » en anglais, qui est un composant semi-conducteur) comme source de lumière, de monter ces LEDs sur un élément d'interconnexion électrique, par exemple de type carte de circuit imprimé (ou carte de type PCB pour *Printed Circuit Board* en anglais), assurant la connexion électrique entre les composants qui y sont montés, et de disposer ensuite l'ensemble LED - PCB ainsi obtenu sur un dissipateur de chaleur (typiquement un radiateur). Ce dissipateur, ayant pour vocation de refroidir la LED en fonctionnement (et de fonctionner comme un radiateur de projecteur), est par après monté dans le projecteur sur un support, par exemple un réflecteur du projecteur.

En particulier, la soudure des composant sur la carte de circuit imprimé consiste en un procédé de dépose d'une pâte à braser, placement des composants suivi d'un passage dans un four de refusion où la pâte à braser va fondre puis se resolidifier afin de fixer les composants électroniques. Parmi ces composants électroniques, on trouvera par exemple une ou des LEDs, un connecteur, des capacités, des résistances. En outre, afin d'assurer la connexion électrique des composants avec le reste du véhicule, on soude également sur la carte une première partie de connecteur (partie femelle). La carte assemblée est ensuite placée sur le dissipateur de chaleur qui est après disposé sur le support du projecteur.

Une fois le dissipateur de chaleur placé sur son support, la liaison électrique entre la carte de circuit imprimé et le reste du véhicule est réalisée par la jonction d'une deuxième partie de connecteur (partie mâle) à la première, la deuxième partie de connecteur étant reliée électriquement à un faisceau de fils électriques destiné à opérer ladite liaison.

De cette façon, le placement du dissipateur de chaleur sur le support n'est pas perturbé par la présence de fils électriques flottants qui peuvent être une entrave à un montage rapide dès lors que ces fils électriques sont libres de se mouvoir et d'occuper les espaces de connexions définis entre le dissipateur et le support.

Toutefois, si le procédé connu de l'état de l'art permet à l'opérateur qui réalise le montage du composant semi-conducteur de se libérer d'une étape additionnelle de gestion des fils électriques lors du placement du dissipateur de chaleur sur son support, ce dernier présente toutefois un écueil majeur : il est coûteux, dans la mesure où, d'une part, le choix des matériaux relatifs à la fabrication de la première partie de connecteur est dicté par des contraintes de mise en oeuvre de la carte de circuit imprimé, à savoir, de hautes températures (dans une plage de valeurs comprises entre environ 200°C et environ 300°C) auxquelles la première partie de connecteur doit résister. Ces températures correspondent en effet aux températures rencontrées lors de l'étape de soudure de la première partie de connecteur montée sur la carte de circuit imprimé. D'autre part, le procédé de montage tel que connu de l'état de l'art est particulièrement long puisqu'une fois le dissipateur placé sur son support d'éclairage, il y a ensuite lieu de connecter la deuxième partie de connecteur, reliée au faisceau de fils électriques, à la première partie de connecteur présente sur la carte de circuit imprimé, et ce, dans un espace confiné, et donc peu accessible, défini entre le support et le dissipateur, ce qui peut s'avérer difficile. Cette difficulté est en outre augmentée par la présence des fils électriques flottants qui gênent la visibilité de l'opérateur lors de l'opération de connexion des deux parties de connecteur et qui sont en outre susceptibles de s'intercaler entre les éléments mécaniques à monter, à cette étape du processus ou à une étape ultérieure.

Ensuite, le procédé connu de l'état de l'art nécessite des opérations additionnelles, et ultérieures à la connexion des deux parties de connecteur, qui consistent en la réalisation de tests avec un matériel dédié pour vérifier que la connexion entre les deux parties de connecteur est correctement établie.

La durée du procédé connu de l'état de l'art constitue sans aucun doute une perte de rentabilité lorsqu'il s'agit de mettre en oeuvre un tel procédé à grande échelle (c'est-à-dire sur une série de projecteurs traités à la chaîne). JP 2014-164.876 divulgue un dispositif selon le préambule de la revendication 1.

L'invention a pour but de pallier les inconvénients de l'état de la technique en procurant un procédé de montage d'un dispositif lumineux de réalisation moins onéreuse tout en permettant une fiabilité satisfaisante ainsi qu'un assemblage aisé et donc rapide des différents éléments dudit dispositif lumineux.

Pour résoudre ce problème, il est prévu suivant l'invention un dispositif selon la revendication 1. L'invention porte également sur un procédé de montage d'un composant semi-conducteur sur un dissipateur de chaleur, le composant semi-conducteur étant connecté à un élément d'interconnexion électrique, lequel procédé comporte :
- une première étape de fixation et de connexion d'un faisceau de fils électriques sur l'élément d'interconnexion électrique ;
- une deuxième étape de fixation du faisceau sur le dissipateur de chaleur ; et
- une troisième étape de fixation de l'élément d'interconnexion électrique sur le dissipateur de chaleur.

De cette façon, dans le cadre de l'application particulière de l'invention qui concerne le montage d'une source de lumière dans un projecteur de véhicule automobile, l'opérateur peut d'abord fixer le faisceau à l'élément d'interconnexion électrique (par exemple une carte de circuit imprimé), fixer le faisceau au dissipateur de chaleur, fixer la carte de circuit imprimé sur le dissipateur, pour ensuite placer le dissipateur de chaleur sur le support du projecteur, de façon à, d'une part, permettre à l'opérateur de se libérer de la gestion du faisceau lors de la fixation de la carte et du dissipateur de chaleur, et, d'autre part, d'éviter le déplacement libre du faisceau lors du montage du dispositif lumineux.

Ainsi, le montage d'un composant semi-conducteur sur un dissipateur de chaleur suivant l'invention permet, non seulement un gain de temps de montage dans la mesure où l'opérateur peut d'abord facilement connecter le faisceau à la carte de circuit imprimé pour ensuite fixer et guider le faisceau dans une position non contraignante lors du montage de la carte et du dissipateur de chaleur, mais aussi un gain en coût de fabrication de la carte de circuit imprimé puisqu'il n'est plus nécessaire de disposer d'une première partie de connecteur placée sur la carte et agencée pour être connectée à une deuxième partie de connecteur reliée au faisceau de fils électriques.

En fait, l'invention permet à l'opérateur d'utiliser un seul connecteur de type monobloc qui peut être fixé à la carte de circuit imprimé. Ce connecteur est inséré dans des trous métallisés de la carte électronique pour être fixé par soudure à la vague sélective. Le boîtier du connecteur subira des températures bien inférieures aux températures comprises entre 200°C à 300°C qui sont utilisées dans un four à refusion conventionnel.

Ce connecteur unique ne doit donc plus obligatoirement être réalisé en un matériau spécifiquement adapté pour supporter les températures élevées relatives au four à refusion conventionnel.

De manière additionnelle, il est observé que l'étape de fixation du faisceau de fils électriques sur le dissipateur de chaleur permet, en fonctionnement, d'éviter une usure par frottement du faisceau sur la surface ou sur les angles du dissipateur de chaleur ou du support dès lors que le faisceau n'est plus libre de se mouvoir sous l'effet des vibrations engendrées par le fonctionnement du véhicule automobile puisqu'il est maintenu dans une position prédéfinie.

Selon différents modes de réalisation du dispositif selon l'invention, qui pourront être pris ensemble ou séparément :
- le composant semi-conducteur comprend au moins une puce émettrice semi-conductrice, de préférence une diode électroluminescente ;
- le dissipateur de chaleur est relié à un support de projecteur de véhicule automobile, de préférence à un réflecteur de projecteur de véhicule automobile, ou dans un support de feux arrière de véhicule ;
- l'élément d'interconnexion électrique est une carte de circuit imprimé ;
- le moyen de tenue comprend une deuxième patte formée en saillie depuis la surface du dissipateur de chaleur, le faisceau de fils électriques étant maintenu entre la première et la deuxième patte et la surface ;
- le faisceau est relié mécaniquement au dissipateur par un moyen de tenue comprenant une première partie formée par un collier de serrage traversé par ledit faisceau et d'une deuxième partie formée d'un pied en un matériau isolant thermique fixant le collier de serrage au dissipateur de chaleur ; le dissipateur est sensiblement en forme de L ;
- le moyen de tenue est sur l'une des branches du L du dissipateur ;
- le dissipateur comprend des ouvertures.

Selon différents modes de réalisation du procédé selon l'invention, qui pourront être pris ensemble ou séparément :
- la première étape consiste en une fixation et une connexion électrique d'un connecteur, lequel connecteur est relié électriquement et mécaniquement au faisceau, sur l'élément d'interconnexion électrique ;
- la deuxième étape consiste en une amenée du faisceau entre au moins une première patte formée en saillie depuis une surface du dissipateur de chaleur et la surface du dissipateur de chaleur, de sorte que le faisceau soit maintenu entre ladite patte et la surface du dissipateur de chaleur ;
- la deuxième étape consiste en outre en une amenée du faisceau entre une deuxième patte formée en saillie depuis la surface du dissipateur de chaleur et la surface du dissipateur de chaleur, de sorte que le faisceau soit maintenu entre la première et la deuxième pattes et la surface du dissipateur de chaleur ;

- la deuxième étape consiste en une amenée du faisceau à travers un collier se serrage, le collier se prolongeant par un pied réalisé en un matériau isolant thermique, le collier étant fixé au dissipateur par ledit pied ;
- la deuxième étape de fixation du faisceau est réalisée antérieurement ou postérieurement à la réalisation de la troisième étape de fixation de l'élément d'interconnexion électrique sur le dissipateur de chaleur; et
- le procédé selon l'invention comprend en outre une quatrième étape de montage du dissipateur de chaleur sur un support d'un projecteur de véhicule automobile.

Enfin, l'invention porte sur un dispositif lumineux pour véhicule automobile, comportant le dispositif selon l'invention.

D'autres caractéristiques et avantages de l'invention ressortiront de la description donnée ci-après, à titre non-limitatif.

Les figures 1a à 1e illustrent un premier mode de réalisation du procédé de montage d'un composant semi-conducteur sur un dissipateur de chaleur selon l'invention.

Les figures 2a et 2b illustrent un deuxième mode de réalisation du procédé de montage d'un composant semi-conducteur sur un dissipateur de chaleur selon l'invention.

Les figures 3a et 3b montrent le dispositif issu du premier mode de réalisation du procédé de la présente invention.

Les figures 4a et 4b illustrent le dispositif selon les figures 3a et 3b dans un projecteur.

Sur ces figures les éléments analogues présentent la même référence.

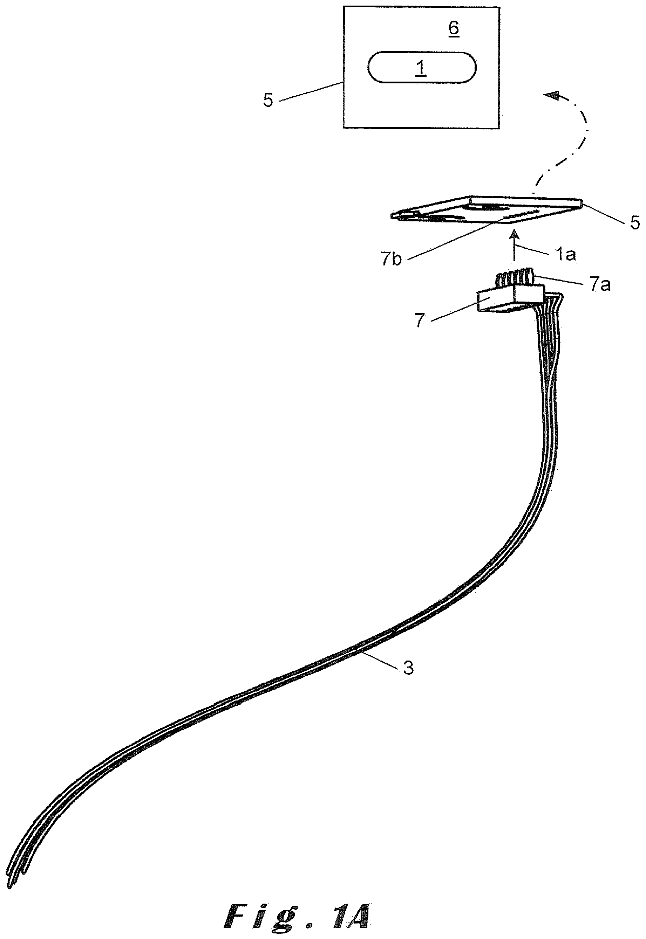

Les étapes de montage d'un composant électronique à semi-conducteur 1 sur un dissipateur de chaleur du premier mode de réalisation du procédé de la présente invention sont illustrées dans les figures 1a à 1e.

Le procédé de montage susmentionné comprend une première étape 1a dans laquelle un faisceau 3 de fils électriques est fixé à une face dorsale d'un élément d'interconnexion électrique 5 qui est une carte de circuit imprimé (carte PCB) supportant sur sa face frontale 6 le composant semi-conducteur par exemple une diode électroluminescente (LED) 1 (figure 1a). Une variante au mode de réalisation dans lequel la LED est montée sur la carte PCB 5 consiste en ce que la LED soit directement montée sur le dissipateur de chaleur puis connectée à la carte PCB, par exemple par soudage par fil.

Lors de cette première étape, le faisceau 3 de fils électriques est fixé à la carte PCB 5 par l'intermédiaire d'un connecteur monobloc 7 (ou connecteur unique) relié électriquement et mécaniquement au faisceau 3, de sorte que la carte PCB 5 soit connectée physiquement et électriquement à chacun des fils électriques du faisceau 3.

La connexion est réalisée par l'insertion, à partir de la face dorsale de la carte PCB 5, d'une pluralité de contacts 7a présente sur le connecteur monobloc 7 dans des trous 7b métallisés de connexion formés dans la carte PCB 5, le connecteur 7 étant ensuite soudé directement à la carte PCB 5 par soudure à la vague.

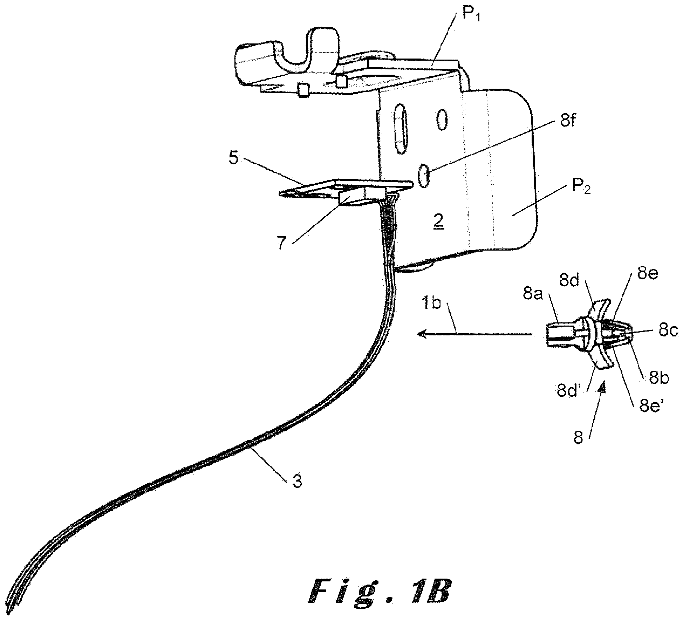

La figure 1b, illustre la deuxième étape 1b de fixation du faisceau 3 sur le dissipateur 2 de chaleur par l'intermédiaire d'un moyen de tenue 8 du faisceau 3.

Le dissipateur 2 de chaleur est défini par une première partie P₁ et une deuxième partie P₂ reliées directement l'une à l'autre et par exemple sensiblement en forme de 'L', c'est-à-dire orientées de sorte qu'un premier plan tangent à la première partie et un deuxième plan tangent à la deuxième partie forment un angle substantiellement droit.

De préférence, le dissipateur 2 comporte des ouvertures destinées à permettre la circulation de l'air.

Dans le premier mode de réalisation du procédé selon l'invention, la deuxième étape 1b consiste en une amenée du faisceau 3 à travers une première partie du moyen de tenue 8 qui est un collier 8a de serrage, le collier 8a se prolongeant par une deuxième partie du moyen de tenue 8 qui est un pied 8b encliquetable.

Le pied 8b comprend une branche d'encliquetage 8c et deux ailerons 8d, 8d' d'appui sur le dissipateur 2 de chaleur.

La branche d'encliquetage 8c prend naissance sur une extrémité du pied 8b où sont reliés chacun des ailerons 8d, 8d' et présente deux coudes 8e, 8e' (ou ailettes) faisant saillie à partir de la branche d'encliquetage 8c dans des directions opposées l'une à l'autre, de façon à former une flèche d'encliquetage composée de la branche d'encliquetage 8c et des deux coudes 8e, 8e', cette flèche étant agencée pour être introduite dans un premier orifice 8f présent sur le dissipateur 2 de chaleur, par exemple sur sa deuxième partie P2.

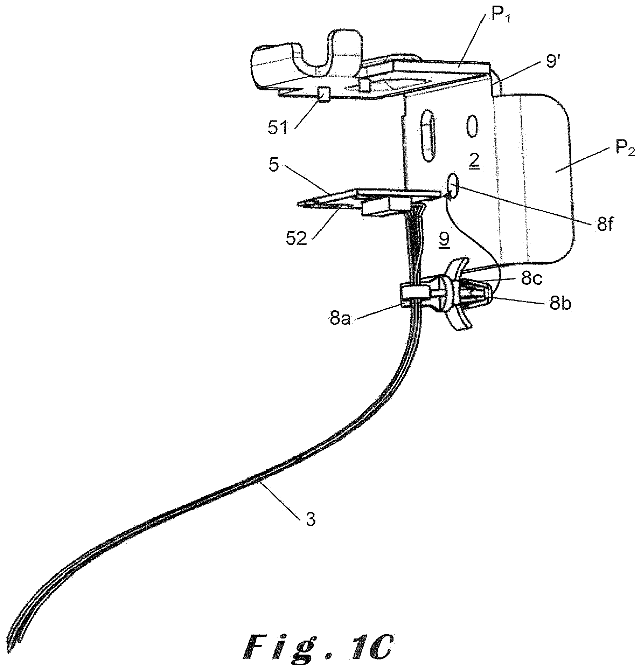

Une fois le faisceau 3 pris dans le collier de serrage 8a, la branche d'encliquetage 8c est introduite (figure 1c) dans le premier orifice 8f de sorte que les coudes 8e, 8e' traversent entièrement le premier orifice 8f et que, lorsque la branche d'encliquetage introduite dans le premier orifice 8f, les deux ailerons 8d, 8d' prennent appui sur une première face 9 de la deuxième partie P₂, tandis que les coudes 8e, 8e' prennent appui sur une deuxième face 9' de la deuxième partie P₂, opposée à la première face 9. De cette façon, le pied 8b est maintenu en appui sur chacune des première et deuxième faces 9,9' de la deuxième partie P₂ du dissipateur 2 de chaleur et le collier 8a est ainsi relié au dissipateur 2 de chaleur.

De préférence, la branche d'encliquetage 8c et les deux coudes 8e, 8e' ne forment qu'une seule pièce de d'attache en forme de flèche réalisée en un matériau souple, de sorte que cette pièce d'attache puisse être facilement introduite à travers le premier orifice 8f par simple poussée, la pièce de connexion, et en particulier les coudes 8e,8e', pouvant se déformer lors du passage à travers le premier orifice 8f et reprendre ensuite sa forme initiale de flèche, de façon à ce que les coudes 8e,8e' puissent prendre appui sur la deuxième face 9' de la deuxième partie P₂ du dissipateur 2 de chaleur.

De préférence, le pied 8b est réalisé en un matériau isolant thermique de sorte que le faisceau 3 soit découplé thermiquement du dissipateur 2 de chaleur lorsque la LED 6 est en fonctionnement et qu'il y échauffement du dissipateur 2 de chaleur.

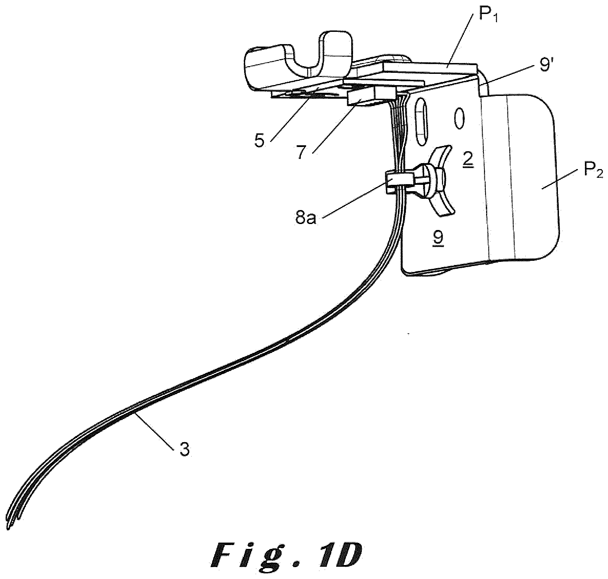

Une fois le faisceau 3 fixé au dissipateur 2 de chaleur, la carte PCB 5 est fixée, lors d'une troisième étape 1d (figure 1d), sur la première partie P₁ du dissipateur 2 de chaleur.

La fixation de la carte PCB 5 (figure 1c) est réalisée par tout moyen connu, par exemple par sertissage d'au moins un pion 51 de forme générale cylindrique faisant saillie depuis la première partie P₁ du dissipateur 2 de chaleur et agencé pour être inséré dans un deuxième orifice 52 (ou une cavité) agencé dans la carte PCB pour accueillir de manière ajustée le pion 51, lequel sera alors écrasé pour venir remplir l'orifice 52 de sorte que la carte soit connectée de manière irréversible à la première partie P₁ du dissipateur 2 de chaleur.

De préférence, la carte PCB 5 est en contact thermique avec le dissipateur 2 de chaleur, de façon à pouvoir contrôler la température du dissipateur 2 de chaleur et à moduler l'intensité du courant électrique traversant la LED afin de garantir sa fiabilité en évitant de dépasser sa température de jonction minimale. La température peut être contrôlée par l'intermédiaire d'une thermistance connectée à la LED et à la carte PCB 5.

De préférence, les étapes 1a à 1d du premier mode de réalisation du procédé revendiqué sont réalisées de manière consécutive, mais pas obligatoirement.

Avantageusement, la deuxième étape 1b de fixation du faisceau 3 est réalisée antérieurement ou postérieurement à la réalisation de la troisième étape 1c de fixation de la carte PCB 5.

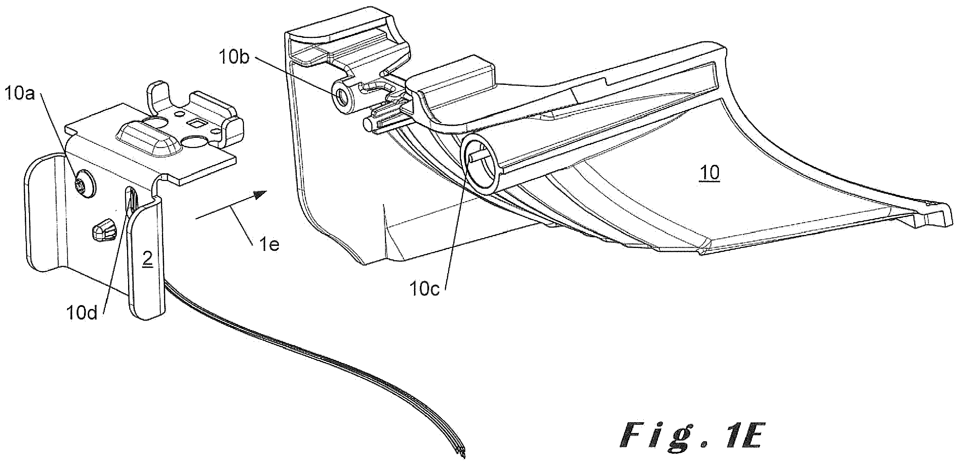

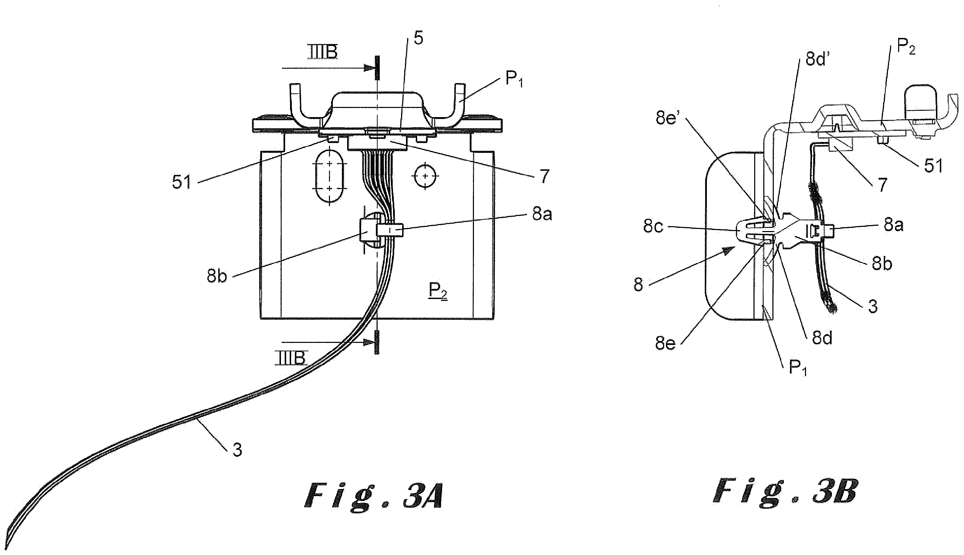

Dès lors que le faisceau 3 et la carte PCB 5 sont fixés au dissipateur 2 de chaleur pour former un dispositif formant un ensemble dissipateur 2 - faisceau 3 - carte PCB 5 tel qu'illustré à la figure 3, cet ensemble peut ensuite être monté, lors d'une quatrième étape, illustrée figure 1e, sur un support 10 d'un projecteur de véhicule automobile.

Dans une variante de réalisation, l'ensemble peut être monté aussi bien sur un support de projecteur avant que sur un support de feux arrière du véhicule.

Comme le montrent les figures 3a et 3b, après la réalisation des étapes 1a à 1d, on obtient un premier dispositif comprenant une LED 1 portée par la carte PCB 5 à laquelle la LED 1 est connectée électriquement. La carte PCB 5 est fixée sur la première partie P₁ du dissipateur 2 de chaleur et connectée au faisceau 3 de fils électriques par le connecteur monobloc 7. Le faisceau 3 est fixé sur la deuxième partie P₂ du dissipateur 2 de chaleur par l'intermédiaire du moyen de tenue 8 comprenant le collier de serrage 8a traversé par le faisceau 3 et le pied 8b fixant le collier de serrage 8a au dissipateur 2 de chaleur.

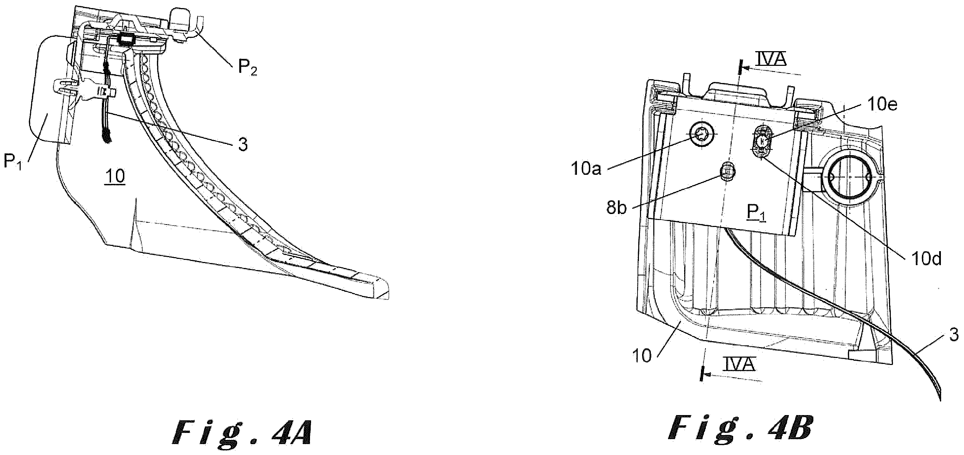

La quatrième étape de montage du dissipateur 2 de chaleur sur un support 10 d'un projecteur de véhicule automobile est représentée sur les figures 4A et 4B. Elle est réalisée en reliant par exemple la première partie P₁ du dissipateur 2 de chaleur au support 10 par l'intermédiaire de moyens de connexion comprenant par exemple :
- une vis 10a agencée pour traverser un troisième orifice présent sur la première partie P₁ et pour être logée dans une deuxième cavité 10b du support 10 présentant un pas de vis interne complémentaire à celui de la première vis ; et
- un pion de positionnement 10e du réflecteur permet d'assurer le positionnement du radiateur dans la direction Y (axe horizontal perpendiculaire au mouvement du véhicule, repère usuel utilisé par l'opérateur) à travers le trou oblong 10d.

Comme le montrent les figures 4a et 4b, la quatrième étape permet d'obtenir un dispositif lumineux pour véhicule automobile comprenant le premier dispositif décrit ci-dessus qui est relié au support 10 du projecteur.

Lors de la réalisation de cette quatrième étape 1e, le placement du dissipateur 2 de chaleur sur le support 10 n'est pas perturbé par la présence de fils électriques flottants et est donc réalisé plus rapidement que le procédé de montage de l'état de l'art.

En outre, dans le procédé selon l'invention, le connecteur, dès lors qu'il est connecté à la carte PCB avant la fixation de cette dernière sur le dissipateur de chaleur, ne doit plus obligatoirement être un connecteur en deux parties, en particulier, comme expliqué plus haut, un connecteur monobloc sera privilégié puisque ce choix constitue un gain de matériau et, en outre, ce connecteur ne doit plus obligatoirement être soudé par un procédé de soudure nécessitant un matériau spécifiquement adapté pour supporter les températures élevées comprises entre 200°C à 300°C

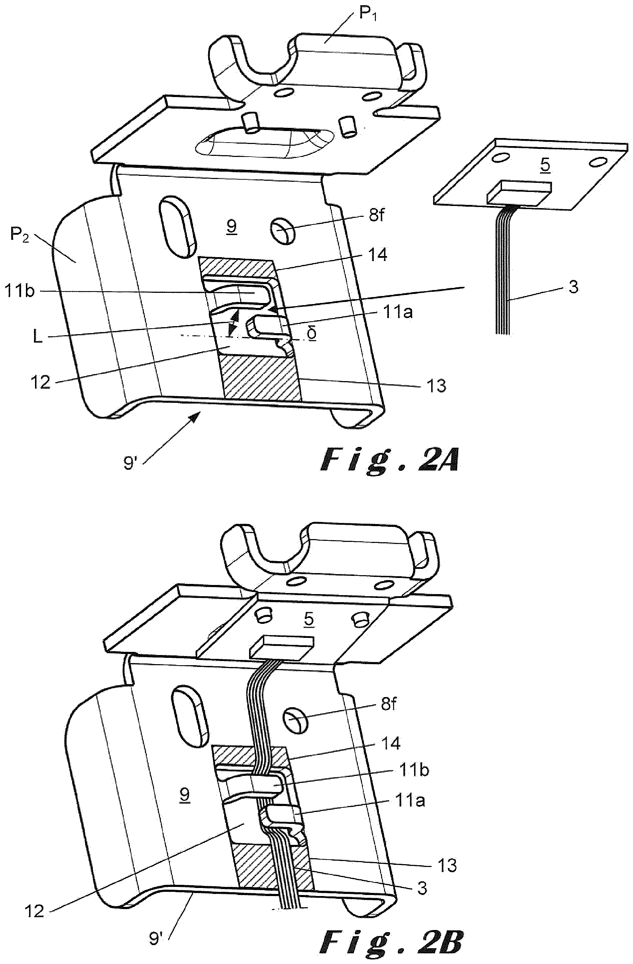

Un deuxième mode alternatif de réalisation du procédé selon l'invention est illustré aux figures 2a et 2b.

Ce deuxième mode de réalisation présente une première et une quatrième étape commune à celle du premier mode de réalisation.

Par contre, ce deuxième mode diffère du premier mode de réalisation en ce que la deuxième étape 2b consiste en une amenée du faisceau 3 entre une première patte 11a et une deuxième patte 11b et une surface S du dissipateur 2 de chaleur définie sur la première face 9 du dissipateur 2. De cette façon, le faisceau 3 est maintenu entre les pattes 11a, 11b et la surface du dissipateur de chaleur, chacune des pattes étant formée en saillie depuis la surface S. Dans une variante de réalisation, il n'est formé qu'une seule patte à partir du dissipateur 2 pour maintenir le faisceau 3, patte qui pourra au besoin être repliée après agencement du faisceau afin de bloquer les potentiels mouvements relatifs du faisceau électrique.

Eventuellement, la deuxième partie P₂ du dissipateur comprend un quatrième orifice 12, chacune des pattes 11a, 11b faisant saillie à partir du bord du quatrième orifice 12 sous les pattes 11a, 11b reliant la première face 9 à la deuxième face 9'.

La présence de ce quatrième orifice permet de faciliter le placement de faisceaux 3 de diamètres élevés puisque, lors du placement de ce type de faisceau entre le dissipateur et chacune des pattes 11a, 11b, une partie du faisceau, dont le diamètre est par exemple supérieur à la distance L, définie entre les pattes 11a, 11b et un plan horizontal passant par la surface S, peut être logée dans l'orifice 12 et le faisceau est maintenu en étau entre, d'une part, les deux pattes 11a, 11b, et, d'autre part, une première 13 et une deuxième 14 parties de surface S définies de part et d'autre de l'orifice 12.

Dans ce contexte, le deuxième mode de réalisation du procédé de montage est moins onéreux et plus rapide que le premier mode de réalisation pour ce procédé. En effet, puisque le faisceau est directement relié au dissipateur 2 par les pattes 11a, 11b formées en saillie depuis la surface S du dissipateur 2 de chaleur, on évite l'utilisation d'une pièce spécifique sur le faisceau électrique du radiateur.

Le dispositif obtenu du deuxième mode de réalisation du procédé selon l'invention diffère donc du premier dispositif issu du premier mode de réalisation du procédé de montage en ce que le moyen de tenue 8 est comprend une première et une deuxième pattes 11a, 11b formées en saillie depuis la surface S (figure 2a) du dissipateur 2 de chaleur, le faisceau 3 de fils électriques étant maintenu entre la première et la deuxième pattes 11a, 11b et la surface S.

Si la description porte sur un mode de réalisation préférentiel du procédé selon l'invention et du dispositif obtenu par un tel procédé dans lequel le composant semi-conducteur est une diode électroluminescente, le dissipateur est un radiateur de projecteur, et l'élément d'interconnexion électrique est la carte PCB, il est entendu que la présente invention n'est pas limitée à ces caractéristiques mais couvre aussi d'autres formes de réalisation faisant intervenir d'autres composants semi-conducteurs, d'autres dissipateurs de chaleur du composant semi-conducteur, ainsi que d'autres éléments d'interconnexion électrique.

## Revendications

1. Dispositif comprenant au moins un composant semi-conducteur (1) connecté à un élément d'interconnexion électrique (5), lequel élément d'interconnexion électrique (5) est fixé sur un dissipateur (2) de chaleur et connecté à un faisceau (3) de fils électriques, le faisceau (3) est relié mécaniquement et électriquement à l'élément d'interconnexion électrique (5) par un connecteur (7) unique, le faisceau (3) étant relié au dissipateur (2) par un moyen de tenue (8) **caractérisé en ce que** le moyen de tenue (8) comprend au moins une première patte (11a) formée en saillie depuis une surface (S) du dissipateur (2) de chaleur, le faisceau de fils électriques (3) étant maintenu entre ladite patte (11a) et la surface (S).

2. Dispositif comprenant au moins un composant semi-conducteur (1) connecté à un élément d'interconnexion électrique (5), lequel élément d'interconnexion électrique (5) est fixé sur un dissipateur (2) de chaleur et connecté à un faisceau (3) de fils électriques, le faisceau (3) est relié mécaniquement et électriquement à l'élément d'interconnexion électrique (5) par un connecteur (7) unique, **caractérisé en ce que** le faisceau (3) est relié au dissipateur (2) par un moyen de tenue (8) et **en ce que** le faisceau (3) est relié mécaniquement au dissipateur (2) par un moyen de tenue (8) comprenant une première partie formée par un collier (8a) de serrage traversé par ledit faisceau (3) et d'une deuxième partie formée d'un pied (8b) en un matériau isolant thermique fixant le collier de serrage (8a) au dissipateur (2) de chaleur.

3. Dispositif selon la revendication 1, **caractérisé en ce que** le composant semi-conducteur (1) comprend au moins une puce émettrice semi-conductrice.

4. Dispositif selon l'une des revendications précédentes, **caractérisé en ce que** le dissipateur (2) de chaleur est relié à un support (10) dans un projecteur de véhicule automobile ou dans un support de feux arrière de véhicule.

5. Dispositif selon l'une des revendications 1 à 3, **caractérisé en ce que** l'élément d'interconnexion électrique (5) est une carte de circuit imprimé.

6. Dispositif selon l'une des revendication 1 ou 3 à 5, **caractérisé en ce que** le moyen de tenue (8) comprenant une deuxième patte (11b) formée en saillie depuis la surface (S) du dissipateur (2) de chaleur, le faisceau de fils électriques (3) étant maintenu entre la première (11a) et la deuxième (11b) pattes et la surface (S).

7. Dispositif selon l'une des revendications précédentes, **caractérisé par le fait que** le dissipateur (2) est sensiblement en forme de L.

8. Dispositif selon la revendication 7, **caractérisé par le fait que** le moyen de tenue (8) est sur l'une des branches du L du dissipateur (5)

9. Dispositif selon l'une des revendications précédentes, **caractérisé par le fait que** le dissipateur (2) comprend des ouvertures.

10. Procédé de montage d'un composant semi-conducteur (1) sur un dissipateur (2) de chaleur, le composant semi-conducteur (1) étant connecté à un élément d'interconnexion électrique (5), lequel procédé est **caractérisé par** :
- une première étape (1a) de fixation et de connexion d'un faisceau de fils électriques (3) sur l'élément d'interconnexion électrique (5) par un connecteur (7) unique ;
- une deuxième étape (1b) de fixation du faisceau (3) sur le dissipateur (2) de chaleur par un moyen de tenue (8) ; et
- une troisième étape (1c) de fixation de l'élément d'interconnexion électrique (5) sur le dissipateur (2) de chaleur.

11. Dispositif lumineux pour véhicule automobile, **caractérisé en ce qu'**il comporte le dispositif selon l'une quelconque des revendications 1 à 9.

## Patentansprüche

1. Vorrichtung, die mindestens ein Halbleiterbauteil (1) enthält, das mit einem elektrischen Verbindungselement (5) verbunden ist, wobei das elektrische Verbindungselement (5) an einem Wärmeableiter (2) befestigt und mit einem Bündel (3) elektrischer Drähte verbunden ist, wobei das Bündel (3) durch einen einzigen Verbinder (7) mechanisch und elektrisch mit dem elektrischen Verbindungselement (5) verbunden ist, wobei das Bündel (3) durch eine Halteeinrichung (8) mit dem Ableiter (2) verbunden ist, **dadurch gekennzeichnet, dass** die Halteeinrichtung (8) mindestens eine erste Lasche (11a) aufweist, die ausgehend von einer Fläche (S) des Wärmeableiters (2) vorstehend geformt ist, wobei das Bündel elektrischer Drähte (3) zwischen der Lasche (11a) und der Fläche (S) gehalten wird.

2. Vorrichtung, die mindestens ein Halbleiterbauteil (1) enthält, das mit einem elektrischen Verbindungselement (5) verbunden ist, wobei das elektrische Verbindungselement (5) an einem Wärmeableiter (2) befestigt und mit einem Bündel (3) elektrischer Drähte verbunden ist, wobei das Bündel (3) durch einen einzigen Verbinder (7) mechanisch und elektrisch mit dem elektrischen Verbindungselement (5) verbunden ist, **dadurch gekennzeichnet, dass** das Bündel (3) durch eine Halteeinrichtung (8) mit dem Ableiter (2) verbunden ist, und dass das Bündel (3) durch eine Halteeinrichtung (8) mechanisch mit dem Ableiter (2) verbunden ist, die einen ersten Teil, der von einer Klemmschelle (8a) gebildet wird, die von dem Bündel (3) durchquert wird, und einen zweiten Teil enthält, der von einem Fuß (8b) aus einem wärmeisolierenden Material gebildet wird, der die Klemmschelle (8a) am Wärmeableiter (2) befestigt.

3. Vorrichtung nach Anspruch 1, **dadurch gekennzeichnet, dass** das Halbleiterbauteil (1) mindestens einen emittierenden Halbleiterchip enthält.

4. Vorrichtung nach einem der vorhergehenden Ansprüche, **dadurch gekennzeichnet, dass** der Wärmeableiter (2) mit einem Träger (10) in einem Scheinwerfer eines Kraftfahrzeugs oder in einem Träger von Fahrzeug-Rücklichtern verbunden ist.

5. Vorrichtung nach einem der Ansprüche 1 bis 3, **dadurch gekennzeichnet, dass** das elektrische Verbindungselement (5) eine Leiterplatte ist.

6. Vorrichtung nach einem der Ansprüche 1 oder 3 bis 5, **dadurch gekennzeichnet, dass** die Halteeinrichtung (8) eine zweite Lasche (11b) enthält, die ausgehend von der Fläche (S) des Wärmeableiters (2) vorstehend geformt ist, wobei das Bündel elektrischer Drähte (3) zwischen der ersten (11a) und der zweiten (11b) Lasche und der Fläche (S) gehalten wird.

7. Vorrichtung nach einem der vorhergehenden Ansprüche, **dadurch gekennzeichnet, dass** der Ableiter (2) im Wesentlichen die Form eines L hat.

8. Vorrichtung nach Anspruch 7, **dadurch gekennzeichnet, dass** die Halteeinrichtung (8) sich auf einem der Schenkel des L des Ableiters (5) befindet.

9. Vorrichtung nach einem der vorhergehenden Ansprüche, **dadurch gekennzeichnet, dass** der Ableiter (2) Öffnungen enthält.

10. Verfahren zur Montage eines Halbleiterbauteils (1) auf einen Wärmeableiter (2), wobei das Halbleiterbauteil (1) mit einem elektrischen Verbindungselement (5) verbunden ist, wobei das Verfahren **gekennzeichnet ist durch**:
- einen ersten Schritt (1a) der Befestigung an und der Verbindung eines Bündels elektrischer Drähte (3) mit dem elektrischen Verbindungselement (5) **durch** einen einzigen Verbinder (7);
- einen zweiten Schritt (1b) der Befestigung des Bündels (3) am Wärmeableiter (2) **durch** eine Halteeinrichtung (8); und
- einen dritten Schritt (1c) der Befestigung des elektrischen Verbindungselements (5) am Wärmeableiter (2).

11. Leuchtvorrichtung für ein Kraftfahrzeug, **dadurch gekennzeichnet, dass** sie die Vorrichtung nach einem der Ansprüche 1 bis 9 aufweist.

## Claims

1. Device including at least one semiconductor component (1) connected to an electrical connection element (5), said electrical connection element (5) is attached to a heat sink (2) and connected to a group (3) of electrical wires, the group (3) being linked mechanically and electrically to the electrical connection element (5) by a single connector (7), the group (3) being linked to the heat sink (2) by holding means (8), **characterized in that** the holding means (8) include at least a first lug (11a) projecting from a surface (S) of the heat sink (2), the group (3) of electrical wires being held between said lug (11a) and the surface (S).

2. Device including at least one semiconductor component (1) connected to an electrical connection element (5), said electrical connection element (5) is attached to a heat sink (2) and connected to a group (3) of electrical wires, the group (3) being linked mechanically and electrically to the electrical connection element (5) by a single connector (7), **characterized in that** the group (3) is linked to the heat sink (2) by holding means (8) and **in that** the group (3) is linked mechanically to the heat sink (2) by holding means (8) comprising a first portion formed by a clamping ring (8a) through which said group (3) passes and a second portion formed by a foot (8b) made of a thermally insulating material attaching the clamping ring (8a) to the heat sink (2).

3. Device according to Claim 1, **characterized in that** the semiconductor component (1) comprises at least one semi-conductive emitter chip.

4. Device according to one of the preceding claims, **characterized in that** the heat sink (2) is linked to a supporting element (10) in a motor-vehicle lamp or inside a vehicle rear-light supporting element.

5. Device according to one of Claims 1 to 3, **characterized in that** the electrical connection element (5) is a printed circuit board.

6. Device according to one of Claims 1 or 3 to 5, **characterized in that** the holding means (8) include a second lug (11b) projecting from the surface (S) of the heat sink (2), the group (3) of electrical wires being held between the first lug (11a) and the second lug (11b) and the surface (S).

7. Device according to one of the preceding claims, **characterized in that** the heat sink (2) is substantially L-shaped.

8. Device according to Claim 7, **characterized in that** the holding means (8) are on one of the branches of the L-shape of the heat sink (5).

9. Device according to one of the preceding claims, **characterized in that** the heat sink (2) has openings.

10. Method for assembling a semiconductor component (1) on a heat sink (2), the semiconductor component (1) being connected to an electrical connection element (5), said method being **characterized by**:
- a first step (1a) in which a group (3) of electrical wires is attached and connected to the electrical connection element (5) using a single connector (7),
- a second step (1b) in which the group (3) is attached to the heat sink (2) using holding means (8), and
- a third step (1c) in which the electrical connection element (5) is attached to the heat sink (2).

11. Lighting device for a motor vehicle, **characterized in that** it includes the device according to any one of Claims 1 to 9.
